(19) Europäisches Patentamt / European Patent Office / Office européen des brevets

(11) **EP 2 515 129 A2**

(12) **DEMANDE DE BREVET EUROPEEN**

(43) Date de publication:
**24.10.2012 Bulletin 2012/43**

(51) Int Cl.:
***G01R 31/40*** *(2006.01)*

(21) Numéro de dépôt: **12163759.9**

(22) Date de dépôt: **11.04.2012**

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**
Etats d'extension désignés:
**BA ME**

(30) Priorité: **22.04.2011 FR 1153518**

(71) Demandeur: **COMMISSARIAT A L'ENERGIE ATOMIQUE ET AUX ENERGIES ALTERNATIVES**
**75015 Paris (FR)**

(72) Inventeur: **Sommervogel, Laurent**
**78350 JOUY-EN-JOSAS (FR)**

(74) Mandataire: **Lucas, Laurent Jacques**
**Marks & Clerk France**
**Conseils en Propriété Industrielle**
**Immeuble Visium**
**22, Avenue Aristide Briand**
**94117 Arcueil Cedex (FR)**

(54) **Procede et dispositif de controle et de localisation de defauts dans une chaine de panneaux photovoltaiques**

(57) Procédé de contrôle et de localisation de défauts électriques dans une chaine (101) de cellules photovoltaïques (102) connectées en série consistant à comparer un nouveau réflectogramme enregistré ($R_{N+1}$) à un ensemble de réflectogrammes préalablement enregistrés et à déterminer celui qui est le plus proche puis à en déduire un diagnostic sur l'existence et le positionnement d'un défaut électrique dans la chaine.

FIG.1

EP 2 515 129 A2

**Description**

La présente invention concerne le domaine du diagnostic de défauts électriques au sein d'une installation photovoltaïque. Elle a pour objet un procédé et un dispositif de contrôle et de localisation de défauts dans une chaine de panneaux photovoltaïques.

Une cellule photovoltaïque individuelle ne peut développer aux bornes de ses électrodes qu'une faible tension, typiquement de l'ordre de 0.5 Volts. Afin d'obtenir une tension suffisante, par exemple pour alimenter un onduleur, il est nécessaire de connecter en série une pluralité de cellules ou panneaux allant jusqu'à un nombre de quarante ou cinquante panneaux pour atteindre certaines tensions requises, typiquement de l'ordre de 200 à 250 Volts.

Si une seule connexion entre deux panneaux d'une chaine est rompue ou présente un défaut, c'est l'intégralité de la chaîne qui devient inopérante. Sans aller jusqu'à un défaut franc, c'est-à-dire une rupture de connexion, il existe également des situations de fonctionnement avec des performances dégradées liées à des défauts résistifs.

De tels défauts peuvent apparaître au moment de l'installation d'une chaine de panneaux, par exemple lors de leur pose sur le toit d'un immeuble, ou encore à n'importe quel instant de leur cycle de fonctionnement.

Lorsqu'un tel défaut apparait, sa localisation peut être longue et fastidieuse car elle nécessite une intervention humaine pour inspecter l'ensemble de la chaîne.

Ainsi, le besoin d'une localisation rapide et automatique d'un défaut dans une chaine de cellules photovoltaïques apparait.

Les solutions connues visant des problématiques similaires sont plurales, elles ne permettent cependant pas d'assurer une localisation des défauts de manière automatique et avec une fiabilité suffisante.

Une première solution consiste en une analyse visuelle de l'état de la connectique de la chaîne ou une analyse thermique afin de détecter un échauffement anormal. Cette solution nécessite l'intervention d'un opérateur humain qui doit procéder par dichotomie pour localiser l'emplacement du défaut dans la chaîne. Pour un montage comportant N cellules, cette solution nécessite jusqu'à un nombre d'inspections égal à log2(N) ce qui est très couteux en temps. Cette première solution présente également l'inconvénient de nécessiter un démontage des éléments de la chaîne, ce qui peut engendrer une fragilisation de l'ensemble.

Une autre solution connue consiste à utiliser une caractérisation tension-courant de la chaine de panneaux photovoltaïques, ce qui permet de détecter un écart entre le fonctionnement réel de la chaine et ses performances optimales mais ne permet pas de localiser l'emplacement du défaut afin de le corriger.

On connait également, notamment à travers le brevet américain 4695788, une méthode basée sur le domaine des signaux hyperfréquences. Un panneau photovoltaïque est ainsi considéré comme capable de rayonner un signal radio préalablement injecté à l'entrée de la chaine. Un opérateur muni d'une antenne portative se déplace le long des panneaux afin de détecter un circuit ouvert dès l'instant où il ne capte plus aucun signal rayonné. L'inconvénient de cette technique est qu'elle ne permet de localiser que des défauts de type circuit ouvert et de plus, elle est difficile à mettre en oeuvre pour des chaines comportant un grand nombre de panneaux car l'atténuation intrinsèque du signal radio rend difficile la localisation d'un défaut en bout de chaîne.

Enfin, on connait également des méthodes basées sur la réflectométrie temporelle. Un exemple de l'application de cette technique aux panneaux photovoltaïques est décrit dans la publication « Experimental Studies of Failure Detection Methods », T. Takashima, J. Yamaguchi, K.Otani,K. Kato, M.Ishida. La méthode de localisation de défauts par réflectométrie temporelle décrite dans ce document utilise des instruments de mesure coûteux tels un générateur de signaux et un oscilloscope qui sont de plus encombrants et donc non compatibles avec des applications mobiles. De plus ces appareils ont une capacité limitée en tension, et enfin les mesures obtenues sont très sensibles au positionnement des câbles et la localisation effectuée est donc peu précise. La réflectométrie classique nécessite en outre une connaissance précise de la vitesse de propagation du signal pour pouvoir en déduire la localisation exacte d'un défaut, ce qui n'est pas le cas dans un environnement de propagation aussi inhomogène que celui visé.

L'invention vise à remédier aux limitations des solutions connues précitées en proposant un procédé et un dispositif permettant dans un premier temps, à l'opérateur qui installe une chaine de panneaux photovoltaïques de s'assurer que chaque panneau est correctement connecté au précédent lors de sa pose, et dans un second temps de localiser tout défaut électrique, tel un court-circuit ou un circuit ouvert, dans la chaine.

L'invention a ainsi pour objet un procédé de contrôle et de localisation de défauts électriques impactant une chaine comportant une pluralité N de cellules photovoltaïques connectées en série, **caractérisé en ce qu'**il comporte au moins les étapes suivantes :

- dans une étape préalable, après la connexion successive de chaque cellule, générer et transmettre, en entrée de ladite chaine, un signal électrique maitrisé et enregistrer, sous forme d'un réflectogramme $R_i$, ledit signal réfléchi sur les singularités de ladite chaine,

- pour chaque nouveau réflectogramme enregistré $R_{N+1}$,

- calculer la différence L2(i) entre ledit nouveau réflectogramme $R_{N+1}$ et chaque réflectogramme $R_i$ préalablement enregistré,

  ■ rechercher la différence minimale L2(j), parmi celles calculées, associée au réflectogramme $R_j$ enregistré le plus proche du nouveau réflectogramme $R_{N+1}$,

■ comparer la différence minimale L2(j) à un seuil adaptatif s(j) qui dépend du nombre j de cellules composant la chaine à l'instant d'enregistrement dudit réflectogramme $R_j$ le plus proche du nouveau réflectogramme $R_{N+1}$,

■ si L2(j) est inférieure ou égale à s(j) : si j est égal au nombre N de cellules composant la chaine, conclure à l'absence de défaut dans la chaine, sinon conclure à une déconnexion entre la j$^{ème}$ et la (j+1)$^{ème}$ cellule de la chaine,

■ si L2(j) est strictement supérieure à s(j) : conclure soit à la connexion d'une nouvelle cellule soit à la présence d'un défaut électrique dans la chaine.

Dans une variante de réalisation, lorsque L2(j) est strictement supérieure à s(j), le procédé selon l'invention comporte en outre, afin de localiser le défaut électrique, une étape de comparaison du nouveau réflectogramme $R_{n+1}$ avec le dernier réflectogramme $R_N$ enregistré, la localisation du défaut électrique étant déterminée à partir de la mesure de l'écart temporel $\Delta t$ entre le début de l'impulsion générée et le point de divergence entre les deux réflectogrammes $R_{N+1}$, $R_N$, ledit écart temporel $\Delta t$ étant converti en une distance entre le point d'entrée de la chaine et le point impacté par le défaut électrique.

Dans une variante de réalisation, le procédé selon l'invention comporte en outre une étape de caractérisation du défaut électrique consistant à comparer le niveau des deux réflectogrammes $R_{N+1}$, $R_N$ après leur point de divergence : si le nouveau réflectogramme $R_{N+l}$ présente un niveau supérieur au réflectogramme de référence $R_N$ alors le défaut électrique est un circuit ouvert sinon il s'agit d'un court-circuit.

Dans une variante de réalisation, la différence L2(i) est déterminée par le calcul de la norme énergie

$$L2(i) = \sum_{k=0}^{K-1} (R_i(k) - R_{N+1}(k))^2 \ ,$$ où K est le nombre d'échantillons considérés pour le calcul.

Dans une variante de réalisation, le seuil adaptatif s(j) est donné par la relation s(j)=a+b.log(j) où a et b sont des paramètres déterminés empiriquement.

L'invention a également pour objet un dispositif de contrôle et de localisation de défauts électriques impactant une chaine comportant une pluralité N de cellules photovoltaïques connectées en série **caractérisé en ce qu'**il comporte au moins :

• une carte électronique numérique connectée à l'entrée de ladite chaine et adaptée d'une part à générer un signal électrique maitrisé destiné à être transmis à travers ladite chaine et d'autre part à recevoir ledit signal électrique réfléchi sur les singularités de ladite chaine et à mesurer son réflectogramme $R_i$,

• et une unité d'acquisition adaptée à recevoir lesdits réflectogrammes $R_i$ transmis par ladite carte et à exécuter les étapes de traitement suivantes pour chaque nouveau réflectogramme enregistré $R_{N+1}$ :

■ calculer la différence L2(i) entre ledit nouveau réflectogramme $R_{N+1}$ et chaque réflectogramme $R_i$ préalablement enregistré,

■ rechercher la différence minimale L2(j), parmi celles calculées, associée au réflectogramme $R_j$ enregistré le plus proche du nouveau réflectogramme $R_{N+1}$,

■ comparer la différence minimale L2(j) à un seuil adaptatif s(j) qui dépend du nombre j de cellules composant la chaine à l'instant d'enregistrement dudit réflectogramme $R_j$ le plus proche du nouveau réflectogramme $R_{N+1}$,

■ si L2(j) est inférieure ou égale à s(j) : si j est égal au nombre N de cellules composant la chaine, conclure à l'absence de défaut dans la chaine, sinon conclure à une déconnexion entre la j$^{ème}$ et la (j+1)$^{ème}$ cellule de la chaine,

■ si L2(j) est strictement supérieure à s(j) : conclure soit à la connexion d'une nouvelle cellule soit à la présence d'un défaut électrique dans la chaine.

Dans une variante de réalisation de l'invention, la carte électronique numérique comporte au moins un circuit à logique programmable, un convertisseur numérique analogique, un convertisseur analogique numérique et des moyens de transmission de données vers ladite unité d'acquisition.

Dans une variante de réalisation, le dispositif selon l'invention comporte en outre un tissu métallisé auquel est relié le câble de masse de ladite carte électronique, ledit tissu métallisé étant préférentiellement disposé sous la chaine de cellules.

Dans une variante de réalisation, l'unité d'acquisition comporte en outre une interface de visualisation sur laquelle est affiché le résultat du contrôle et/ou de la localisation de défauts.

L'invention a également pour objet une utilisation dudit procédé ou dudit dispositif pour le déploiement d'une chaine comportant une pluralité N de cellules photovoltaïques connectées en série.

L'invention a également pour objet une utilisation dudit procédé ou dudit dispositif pour le contrôle du fonctionnement électrique d'une chaine comportant une pluralité N de cellules photovoltaïques connectées en série.

D'autres caractéristiques et avantages de l'invention apparaîtront à l'aide de la description qui suit faite en regard de dessins annexés qui représentent :

-   la figure 1, une illustration du dispositif de contrôle et de localisation de défauts selon l'invention,

- la figure 2, un synoptique de la carte électronique numérique 103 que comporte le dispositif selon l'invention,
- la figure 3, une illustration d'un mode de réalisation particulier du dispositif selon l'invention,
- la figure 4, un organigramme décrivant les étapes du procédé selon l'invention,
- la figure 5, le diagramme des réflectogrammes mesurés au cours de la pose en série de plusieurs panneaux photovoltaïques,
- la figure 6, le diagramme d'un réflectogramme mesuré pour différents types de défauts électriques impactant une chaine de panneaux photovoltaïques.

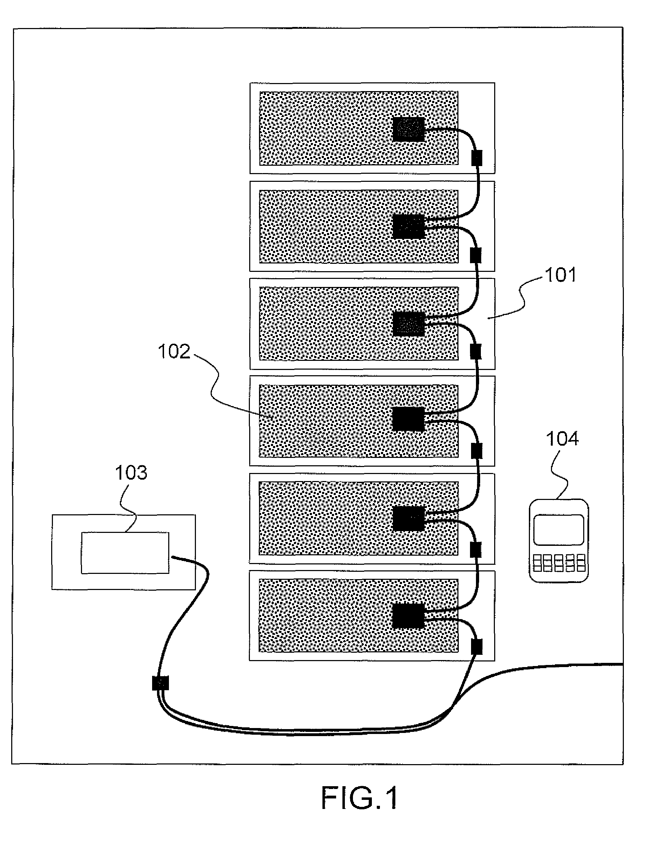

La figure 1 illustre, sur un schéma, la mise en oeuvre du dispositif selon l'invention pour le diagnostic des défauts impactant une chaine 101 de panneaux ou cellules photovoltaïques 102. Le dispositif selon l'invention comporte une carte électronique numérique 103 connectée à l'entrée de la chaine de panneaux photovoltaïques, par exemple au moyen d'un adaptateur de type SMA, réalisant à la fois la fonction de générateur de signal électrique destiné à être transmis à travers ladite chaine 101 et de dispositif de mesure des signaux réfléchis sur les singularités de la chaine.

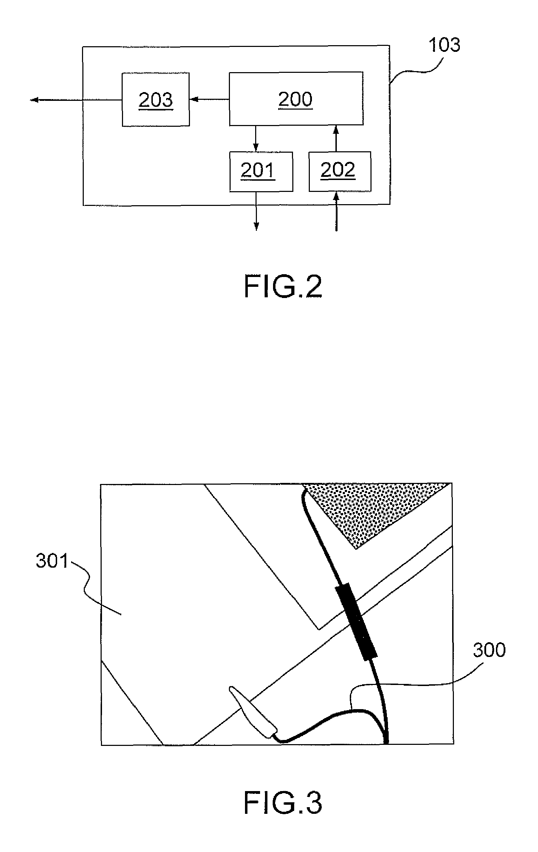

Un synoptique de la carte électronique numérique 103 est représenté à la figure 2. Elle comporte au moins un circuit intégré 200, par exemple un circuit à logique programmable (FPGA), un convertisseur numérique analogique 201 adapté à convertir le signal numérique généré par ledit circuit en un signal analogique et un convertisseur analogique numérique 202 adapté à convertir le signal analogique réfléchi sur les singularités de la chaine 101 et reçu par ladite carte 103 en un signal numérique. Le signal numérique reçu par le circuit intégré 200 est exploité pour réaliser un réflectogramme. La carte 103 comporte en outre des moyens 203 de transmission filaire ou sans fils de données vers un équipement externe.

Le dispositif selon l'invention comporte en outre une unité d'acquisition 104, par exemple une unité sans fils tel un ordinateur portable, un assistant numérique personnel (PDA) ou un téléphone intelligent (Smartphone), adaptée à récupérer les mesures de réflectogrammes réalisées par la carte électronique 103 et à analyser ces mesures afin d'en déduire une localisation précise d'un défaut électrique dans la chaine 101. L'analyse des mesures peut, notamment, être réalisée au moyen d'un logiciel de traitement de signal implémenté dans l'unité d'acquisition 104. Une interface de visualisation peut également être exécutée par la dite unité 104 aux fins d'afficher les résultats du diagnostic réalisé sur la chaine 101. L'unité d'acquisition n'est pas limitée à un terminal sans fils et peut également être connectée par des moyens filaires à la carte électronique 103, par exemple au moyen d'un câble USB.

La figure 3 illustre, sur un schéma, un mode particulier de l'invention, pour lequel la masse 300 de la carte électronique 103 est connectée à un tissu métallisé 301 disposé sous la chaine 101 de panneaux photovoltaïques. Dans le cas d'une chaine installée sur le toit d'un bâtiment, le tissu métallisé 301 est étendu sur le bâti. Dans un autre mode de réalisation de l'invention, le câble de masse 300 de la carte électronique 103 peut également être connecté à un câble de retour, déployé au fur et à mesure le long de la chaine 101, pour finalement être connecté au dernier panneau.

Le procédé selon l'invention trouve son application pour au moins deux scénarios de diagnostic du fonctionnement d'une chaine de panneaux photovoltaïques.

Une première application du procédé selon l'invention consiste à valider le bon déploiement initial de la chaine. Une seconde application porte sur le contrôle, à tout moment, d'une anomalie engendrée par un défaut électrique.

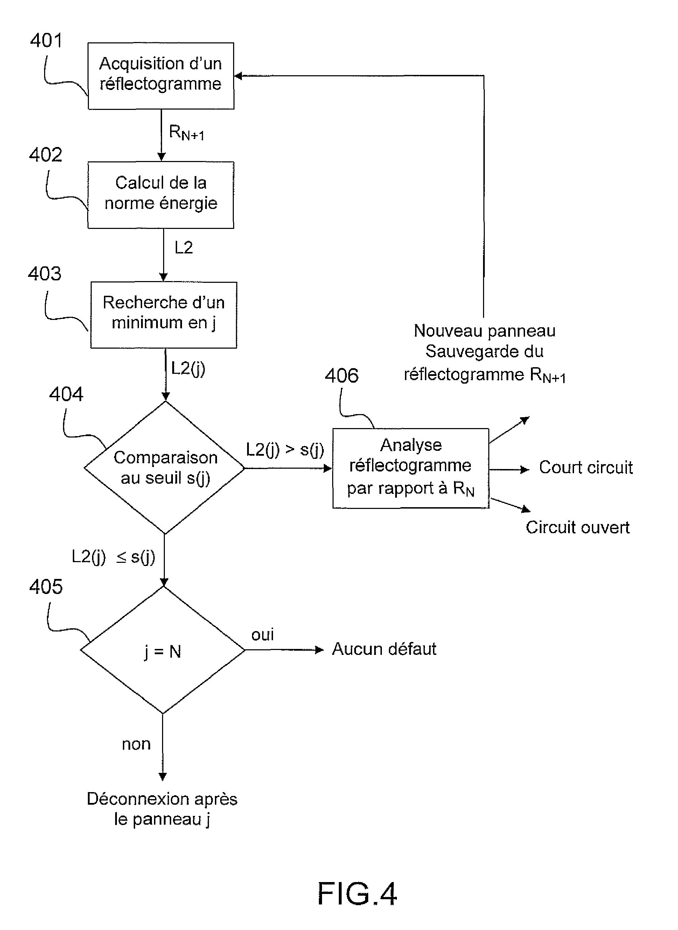

La figure 4 illustre les étapes de mise en oeuvre du procédé selon l'invention dans l'une ou l'autre application.

Considérons une chaine 101 composée d'un nombre N de panneaux photovoltaïques, dans une première étape 401, la carte électronique 103 génère une impulsion électrique, la transmet au travers de la chaine 101 et réalise l'acquisition d'un réflectogramme $R_{N+1}$, correspondant au signal électrique réfléchi sur les singularités de la ligne électrique constituée par ladite chaine 101. Les mesures réalisées par la carte 103 sont effectuées périodiquement ou à des instants commandés par l'opérateur. Lors de la pose de la chaine 101, à chaque nouveau panneau connecté, la carte 103 mesure le réflectogramme correspondant et le transmet à l'unité d'acquisition 104 qui l'enregistre en mémoire, par exemple dans une base de données contenant les réflectogrammes associés aux N panneaux consécutivement connectés pour former la chaine 101.

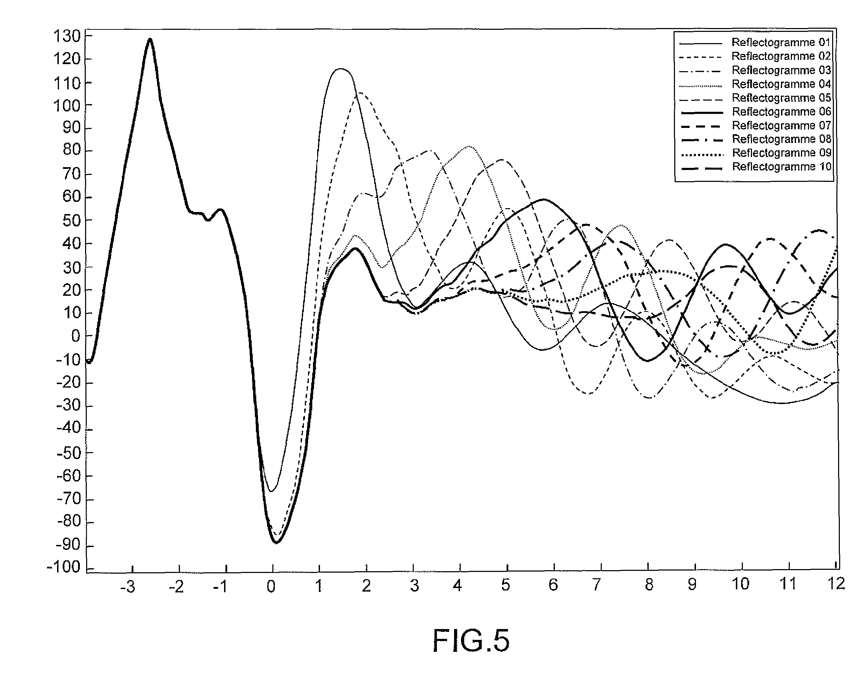

A titre d'illustration, la figure 5 schématise, sur un diagramme temps-amplitude, les réflectogrammes obtenus successivement lors de la connexion d'une chaine de dix panneaux photovoltaïques. On observe que, pour chaque panneau, le pic de l'impulsion réfléchie est décalé temporellement car la distance entre le point d'injection du signal et l'extrémité de la chaine augmente pour chaque nouveau panneau connecté.

Dans une deuxième étape 402, une comparaison est réalisée entre chaque réflectogramme stocké en mémoire et le dernier réflectogramme $R_{N+1}$ mesuré. Cette comparaison a pour but de déterminer une information sur la différence entre deux réflectogrammes. L'erreur quadratique moyenne peut par exemple être utilisée à cette fin. Cette erreur peut, notamment, être déterminée en calculant la norme énergie à l'aide de la relation suivante:

$$L2(i) = \sum_{k=0}^{K-1} (R_i(k) - R_{N+1}(k))^2$$ , où K est le nombre d'échantillons considérés pour le calcul.

Dans une troisième étape 403, une recherche du minimum L2(j), parmi les N normes L2(i) mémorisées, est réalisée. La norme L2(j) de valeur minimum est ensuite comparée, dans une quatrième étape 404, à un seuil adaptatif s(j) qui dépend du nombre j de panneaux composant la chaine 101 au moment où le réflectogramme $R_j$ a été enregistré. Le seuil adaptatif s(j) est de la forme s(j) = a +b.log(j), où a et b sont des paramètres déterminés de façon empirique. Un tel seuil logarithmique a pour fonction de compenser l'atténuation exponentielle subie par le signal injecté lors de sa propagation le long de la chaine 101 et ainsi d'éliminer des minima qui ne résulteraient pas d'une correspondance entre le réflectogramme courant $R_{N+1}$ et un des réflectogrammes enregistrés en mémoire.

Si la norme minimale L2(j) est inférieure ou égale au seuil s(j), alors cela signifie que le dernier réflectogramme $R_{N+1}$ mesuré est similaire au réflectogramme mesuré après la pose du $j^{ème}$ panneau de la chaine 101. Si j est égal à N, cela signifie que le réflectogramme $R_{N+1}$ est identique au dernier réflectogramme enregistré et par conséquent qu'aucun changement n'est intervenu. Si j est strictement inférieur à N, cela signifie qu'une déconnexion a eu lieu après le $j^{ème}$ panneau de la chaine 101.

Si la norme minimale L2(j) est strictement supérieure au seuil s(j), alors une étape supplémentaire 406 d'analyse du réflectogramme $R_{N+1}$ est nécessaire pour réaliser un diagnostic de la situation.

Dans le cas du déploiement initial de la chaine, on prend l'hypothèse qu'aucun défaut électrique de type court-circuit ou circuit ouvert ne peut se produire, le fait que le dernier réflectogramme acquis ne soit similaire à aucun des autres réflectogrammes antérieurement enregistrés signifie alors qu'il correspond à la pose d'un nouveau panneau dans la chaine 101. Ce diagnostic peut être confirmé par l'analyse du réflectogramme $R_{N+1}$, en effet si celui-ci présente un pic d'énergie décalé temporellement du dernier réflectogramme enregistré, comme illustré à la figure 5, alors le procédé peut conclure à la pose d'un nouveau panneau et valider la connexion de ce panneau lorsque le réflectogramme correspondant est bien mesuré et enregistré.

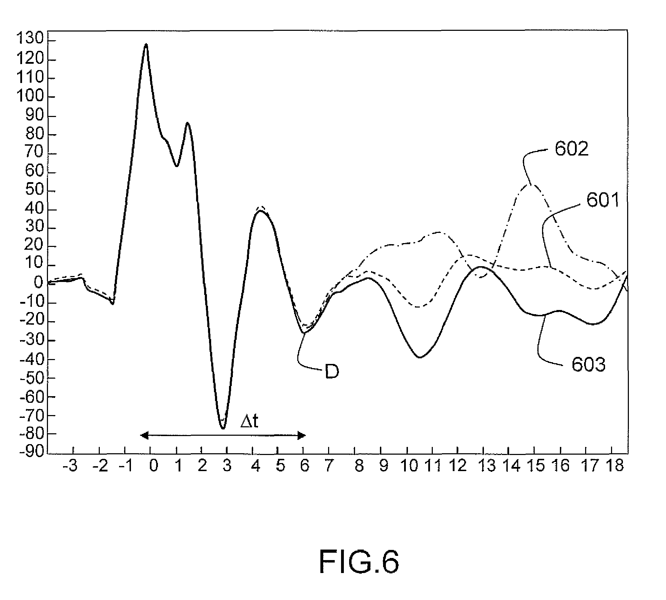

Lorsque la chaine 101 est entièrement installée et que le procédé selon l'invention est utilisé à des fins de contrôle des défauts électriques pouvant survenir, le fait que le dernier réflectogramme acquis ne soit similaire à aucun des autres réflectogrammes antérieurement enregistrés signifie cette fois qu'un défaut de type court-circuit ou circuit ouvert est apparu dans l'équipement photovoltaïque. Dans ce cas, une comparaison du réflectogramme $R_{N+1}$ courant avec le dernier réflectogramme $R_N$ enregistré permet de localiser le défaut et de diagnostiquer sa nature. Cette comparaison est illustrée à la figure 6. Le réflectogramme $R_N$ 601 est représenté ainsi que le réflectogramme $R_{N+1}$ dans deux cas de figure 602, 603 correspondants respectivement à un défaut de type circuit ouvert et court-circuit. Pour localiser le défaut électrique, il convient de déterminer le point de divergence D entre les deux courbes. L'écart temporel $\Delta t$ entre ce point de divergence et le début de l'impulsion générée est caractéristique de la distance d entre le point d'injection du signal et le défaut électrique. Cette distance est déduite à partir de l'écart $\Delta t$ mesuré, de l'écart entre deux pics de deux réflectogrammes $R_N$, $R_{N+1}$ successifs et de la distance de câblage entre deux panneaux consécutifs de la chaine. Ainsi, il est possible de localiser le défaut électrique par sa distance au point d'entrée de la chaine à partir de la connaissance préalable de la vitesse de propagation du signal dans le câble.

En outre, il est possible de caractériser le type de défaut en observant la tendance du réflectogramme $R_{N+1}$ après le point de divergence. Si la courbe 602 est au dessus de la courbe de référence $R_N$, alors l'impédance est supérieure à l'impédance caractéristique ce qui est une indication d'un défaut de type circuit ouvert. Si la courbe 603 est en dessous de la courbe de référence $R_N$, alors il s'agit d'une chute d'impédance par rapport à l'impédance caractéristique ce qui traduit l'existence d'un court-circuit.

L'étape 401 d'acquisition des réflectogrammes est exécutée par la carte numérique 103 qui transmet ensuite ces mesures à l'unité d'acquisition 104 laquelle exécute le reste des étapes de mise en oeuvre du procédé selon l'invention. Le logiciel de traitement de signal exécuté par l'unité 104 peut être couplé à une interface homme-machine qui permet d'afficher en temps réel le diagnostic réalisé, qui prend essentiellement quatre états, connexion d'un nouveau panneau, déconnexion de la chaine après le $i^{ème}$ panneau, court-circuit localisé après le $i^{ème}$ panneau, circuit ouvert localisé après le $i^{ème}$ panneau.

L'invention présente l'avantage de pallier les imprécisions des techniques de réflectométrie temporelle classiques, en exploitant les réflectogrammes mesurés comme des signatures associées à un état de l'installation photovoltaïque. L'invention ne réalise pas de mesures directes de localisation de défauts sur les réflectogrammes mesurés, ce qui présenterait l'inconvénient d'un manque de fiabilité lié à une maitrise difficile de la vitesse de propagation et du positionnement des câbles reliant les différents panneaux constituant la chaine.

## Revendications

1. Procédé de contrôle et de localisation de défauts électriques impactant une chaine (101) comportant une pluralité N de cellules photovoltaïques (102) connectées en série, **caractérisé en ce qu'**il comporte au moins les étapes suivantes :

• dans une étape préalable, après la connexion successive de chaque cellule (102), générer et transmettre (401), en entrée de ladite chaine (101), un signal électrique maitrisé et enregistrer, sous forme d'un réflectogramme ($R_i$), ledit signal réfléchi sur les singularités de ladite chaine (101),

• pour chaque nouveau réflectogramme enregistré ($R_{N+1}$),

■ calculer (402) la différence L2(i) entre ledit nouveau réflectogramme ($R_{N+1}$) et chaque réflectogramme ($R_i$) préalablement enregistré,

■ rechercher (403) la différence minimale L2(j), parmi celles calculées, associée au réflectogramme ($R_j$) enregistré le plus proche du nouveau réflectogramme ($R_{N+1}$),

■ comparer (404) la différence minimale L2 (j) à un seuil adaptatif s(j) dépendant du nombre j de cellules composant la chaine à l'instant d'enregistrement dudit réflectogramme ($R_j$) le plus proche du nouveau réflectogramme ($R_{N+1}$),

■ si L2(j) est inférieure ou égale à s(j) : si j est égal au nombre N de cellules composant la chaine, conclure à l'absence de défaut dans la chaine (101), sinon conclure à une déconnexion entre la $j^{ème}$ et la $(j+1)^{ème}$ cellule de la chaine (101),

■ si L2(j) est strictement supérieure à s(j) : conclure soit à la connexion d'une nouvelle cellule (102) soit à la présence d'un défaut électrique dans la chaine (101).

2. Procédé selon la revendication 1 **caractérisé en ce que**, lorsque L2(j) est strictement supérieure à s(j), il comporte en outre, afin de localiser le défaut électrique, une étape (406) de comparaison du nouveau réflectogramme ($R_{N+1}$) avec le dernier réflectogramme ($R_N$) enregistré, la localisation du défaut électrique étant déterminée à partir de la mesure de l'écart temporel $\Delta t$ entre le début de l'impulsion générée et le point de divergence entre les deux réflectogrammes ($R_{N+1}$, $R_N$), ledit écart temporel $\Delta t$ étant converti en une distance entre le point d'entrée de la chaine (101) et le point impacté par le défaut électrique.

3. Procédé selon la revendication 2 **caractérisé en ce qu'**il comporte en outre une étape de caractérisation du défaut électrique consistant à comparer le niveau des deux réflectogrammes ($R_{N+1}$, $R_N$) après leur point de divergence : si le nouveau réflectogramme ($R_{N+1}$) présente un niveau supérieur au réflectogramme de référence ($R_N$) alors le défaut électrique est un circuit ouvert sinon il s'agit d'un court-circuit.

4. Procédé selon l'une des revendications précédentes **caractérisé en ce que** la différence L2(i) est déterminée par le calcul de la norme énergie

$$L2(i) = \sum_{k=0}^{K-1} (R_i(k) - R_{N+1}(k))^2 \text{, où K est le}$$

nombre d'échantillons considérés pour le calcul.

5. Procédé selon l'une des revendications précédentes **caractérisé en ce que** le seuil adaptatif s(j) est donné par la relation s(j)=a+b.log(j) où a et b sont des paramètres déterminés empiriquement.

6. Dispositif de contrôle et de localisation de défauts électriques impactant une chaine (101) comportant une pluralité N de cellules photovoltaïques (102) connectées en série **caractérisé en ce qu'**il comporte au moins :

• une carte électronique numérique (103) connectée à l'entrée de ladite chaine (101) et adaptée d'une part à générer un signal électrique maitrisé destiné à être transmis à travers ladite chaine (101) et d'autre part à recevoir ledit signal électrique réfléchi sur les singularités de ladite chaine (101) et à mesurer son réflectogramme ($R_i$),

• et une unité d'acquisition (104) adaptée à recevoir lesdits réflectogrammes ($R_i$) transmis par ladite carte (103) et à exécuter les étapes de traitement suivantes pour chaque nouveau réflectogramme enregistré ($R_{N+1}$) :

■ calculer (402) la différence L2(i) entre ledit nouveau réflectogramme ($R_{N+1}$) et chaque réflectogramme ($R_i$) préalablement enregistré,

■ rechercher (403) la différence minimale L2(j), parmi celles calculées, associée au réflectogramme ($R_j$) enregistré le plus proche du nouveau réflectogramme ($R_{N+1}$),

■ comparer (404) la différence minimale L2 (j) à un seuil adaptatif s(j) qui dépend du nombre j de cellules composant la chaine à l'instant d'enregistrement dudit réflectogramme ($R_j$) le plus proche du nouveau réflectogramme ($R_{N+1}$),

■ si L2(j) est inférieure ou égale à s(j) : si j est égal au nombre N de cellules composant la chaine, conclure à l'absence de défaut dans la chaine (101), sinon conclure à une déconnexion entre la $j^{ème}$ et la $(j+1)^{ème}$ cellule de la chaine (101),

■ si L2(j) est strictement supérieure à s(j) : conclure soit à la connexion d'une nouvelle cellule (102) soit à la présence d'un défaut électrique dans la chaine (101).

7. Dispositif selon la revendication 6 **caractérisé en ce que** ladite carte électronique numérique (103) comporte au moins un circuit à logique programmable (200), un convertisseur numérique analogique (201), un convertisseur analogique numérique (202) et des moyens de transmission de données (204) vers ladite unité d'acquisition (104).

8. Dispositif selon l'une des revendications 6 ou 7 **caractérisé en ce qu'**il comporte en outre un tissu métallisé (301) auquel est relié le câble de masse (300) de ladite carte électronique (103), ledit tissu métallisé étant préférentiellement disposé sous la chaine de cellules (101).

9. Dispositif selon l'une des revendications 6 à 8 **caractérisé en ce que** l'unité d'acquisition (104) comporte en outre une interface de visualisation sur laquelle est affiché le résultat du contrôle et/ou de la localisation de défauts.

10. Utilisation du procédé selon l'une des revendications 1 à 5 ou du dispositif selon l'une des revendications 6 à 9 pour le déploiement d'une chaine (101) comportant une pluralité N de cellules photovoltaïques (102) connectées en série.

11. Utilisation du procédé selon l'une des revendications 1 à 5 ou du dispositif selon l'une des revendications 6 à 9 pour le contrôle du fonctionnement électrique d'une chaine (101) comportant une pluralité N de cellules photovoltaïques (102) connectées en série.

FIG.1

FIG.2

FIG.3

FIG.4

FIG.5

FIG.6